# EUROPEAN PATENT SPECIFICATION

(11) **EP 0 396 221 B1**
(45) Date of publication and mention of the grant of the patent: **27.09.1995**
(21) Application number: 90301199.7
(22) Date of filing: 06.02.1990
(51) Int. Cl.: G11C 11/22, H01L 27/108

(54) **Integrated ferroelectric capacitor**
Integrierter ferro-elektrischer Kondensator
Condensateur ferro-électrique intégré

(30) Priority: 05.05.1989 US 347826
(43) Date of publication of application: 07.11.1990
(73) Proprietor: RAMTRON INTERNATIONAL CORPORATION, Colorado Springs, Colorado 80921 (US)
(72) Inventor: Gnadinger, Alfred P., Colorado Springs, Colorado 80906 (US); Horton, Richard L., Monument, Colorado 80132 (US)
(74) Representative: Burke, Steven David

(56) References cited:
- EP-A- 0 236 696
- EP-A- 0 338 157
- IBM TECHNICAL DISCLOSURE BULLETIN, vol. 18, no. 12, May 1976, pages 3953-3954,New York, US; N.G. VOGL, Jr.: "Making a one-device memory cell"

## Description

The present invention relates to a new semiconductor structure involving ferroelectric capacitors, and a method for producing such a structure.

Ferroelectric materials are of interest today because when used as dielectrics in capacitors, they can form and be used as nonvolatile memory devices. One example of a nonvolatile use involving ferroelectric material is shown in Dimmler et al. U.S. Patent 4,809,225, owned by Ramtron Corporation. Further examples are shown in published European patent applications of Ramtron Corporation, such as Publication 278,167 for a Self Restoring Ferroelectric Memory (S. Eaton, Jr., inventor) and Publication 299,633 for a Progammable Capacitance Divider (S. Eaton, Jr., M. Parris, inventors), both of which are the subject of allowed U.S. patent applications.

Development efforts are directed toward a nonvolatile memory technology based on the switching properties of ferroelectric materials. One such ferroelectric material is known as "PZT" which refers generally to a mixture or solution comprising lead zirconate titanate, i.e. where lead, zirconium, titanium, and oxygen are combined in an ABO₃ type Perovskite crystalline structure. Important parameters for such a technology include (1) the threshold or coercive voltage, (2) the amount of charge that can be switched, e.g. microcoulombs per square centimeter, (3) switching speed, (4) retention and endurance, and (5) breakdown voltage.

We have found that PZT has surprisingly large switched charge of up to 20 microcoulombs per square centimeter. This is more than needed in a conventional implementation where a ferroelectric capacitor is placed next to or on top of active circuitry in a monolithic or integrated device. So large a switched charge allows the ferroelectric capcitor to be scaled aggressively and still maintain sufficient signal levels for sensing. Methods for sensing are disclosed in the aforementioned patents and/or published patent applications.

Curiously, PZT exhibits a large dielectric permitivity. This makes it an attractive material for the dielectric storage material in a volatile DRAM cell. We note that the use of PZT for a dielectric material in a memory cell capacitor was disclosed and claimed in Ramtron's Programmable Capacitance Divider U.S. S.N. 069,389 filed July 2, 1987 in the names of Sheffield Eaton and Michael Parris.

For the present application the state of the art also comprises European Patent Application EP-A-0,338,157, by virtue of Article 54(3) EPC. This document discloses the use of a ferroelectric material as the dielectric in a DRAM memory cell capacitor.

In all types of semiconductor memory cells of which we are aware, it is desirable to minimize the cell area because the cell area dominates the ultimate chip area. This, in turn, directly relates to cost and possible product density. The Programmable Capacitance Divider application did not disclose topography for a cell.

A principal object of the present invention, therefore, is to create a memory cell that is no larger than a single transistor which is the ultimate scaling potential of any technology.

According to one aspect of the present invention there is provided a compact one transistor, one capacitor memory cell for an integrated circuit memory comprising: first and second spaced apart isolation regions with a substrate therebetween; spaced apart source and drain regions with a gate electrode therebetween but above the substrate, including a gate dielectric on the top and sides of the gate electrode; contact windows to the source and drain regions; a capacitor electrode in the contact window for the source region; a layer of a high dielectric constant ferroelectric material in the contact window for the source region; an upper capacitor electrode upon the layer of ferroelectric material over the source region; a bit line conductor contacting the drain and a further conductor in contact with the upper capacitor electrode, the upper surfaces of the bit line conductor and the further conductor being above the gate dielectric upper surface and being substantially planar so as to obtain a substantially planar upper memory cell surface.

The present invention also provides a method of forming a compact one transistor, one capacitor memory cell for an integrated circuit memory comprising the steps of: forming first and second spaced apart isolation regions with substrate therebetween; forming spaced apart source and drain regions with a gate electrode therebetween but above the substrate, including forming gate dielectric on the top and sides of the gate electrode; the method including opening contact windows to the source and drain regions; forming a capacitor electrode in the contact window for the source region; adding a layer of a high dielectric constant ferroelectric material in the contact window for the source region and etching back the ferroelectric material so that portions thereof remain in only the contact windows; removing the ferroelectric material from the drain contact window; forming an upper capacitor electrode upon the ferroelectric layer over the source region; forming a bit line conductor contacting the drain and forming a further conductor in contact with the upper capacitor electrode, the upper surfaces of the bit line conductor and the further conductor being above the gate dielectric upper surface and being substantially planar, whereby a substantially planar upper memory cell surface is obtained.

In one of its aspects, the present invention thus comprises a memory cell topography wherein a single transistor is used in each memory cell, illustratively a field effect transistor. Directly over the surface or drain region of the transistor, a ferroelectric material, preferably PZT, is disposed. A plate line (as that term is used in the "Self-Restoring Ferroelectric Memory" U.S. and E.P.O. Applications) or ground line contacts the ferroelectric material. A word line is used to form the gate electrode for the transistor. Illustratively, the word line can be formed of first or second layers of polysilicon. A bit line contacts the other source/drain region.

In one method of forming such a structure, after contact windows are opened to the source gate, and drain regions, silicide is formed, preferably platinum silicide, in the contact windows. Then PZT is formed and etched back so that it is left in the contact window. The PZT is etched out of the drain and gate contact windows. Thereafter, the top electrode is formed. Standard CMOS processing may then occur, including metallization and passivation.

The memory cell can be used in volatile and nonvolatile modes. In the volatile mode, it operates as a normal one transistor, one capacitor cell, but has high charge storage capability due to the high dielectric constant of PZT. In a nonvolatile mode, which is fully described in Ramtron's E.P.O. published patent applications referenced supra, the orientation of dipoles provides the physical mechanism for data storage.

In describing the present invention, reference is made to accompanying drawings wherein:
Figure 1 is a schematic diagram of a memory cell using ferroelectric material;
Figure 2 is a sectional diagram through a memory cell according to one embodiment of this invention to show how the relative parts are configured, and generally conforming to Figure 1; and
Figure 3 is a sectional diagram through a second embodiment of the present invention.

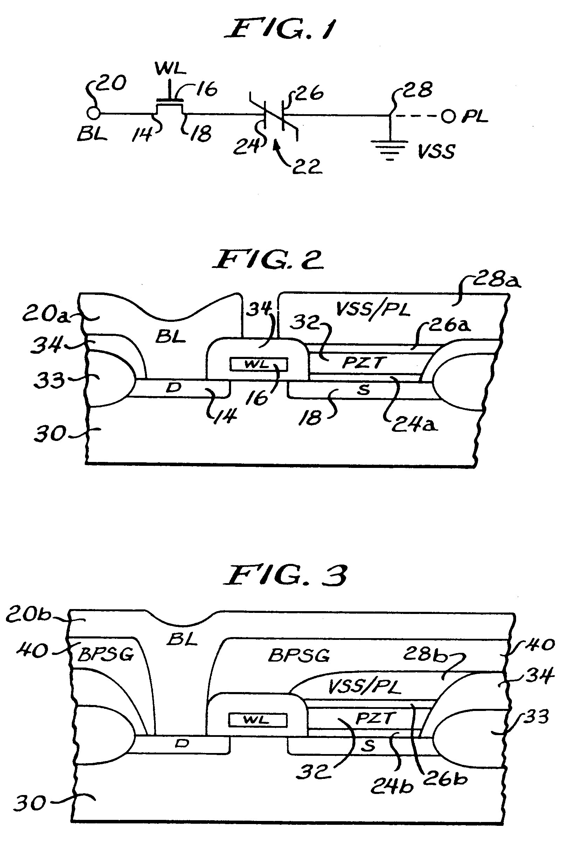

Figure 1 illustrates a memory cell 10 in electrical schematic form. Cell 10 includes a switching device such as a field effect transistor 12, but it should be understood that other types of transistors could be used within the scope of this invention. Illustratively, transistor 12 includes a drain 14, a gate (control electrode) 16, and a source 18. The drain is coupled at contact 20 to a bit line (BL) 20. The gate is coupled to a word like (WL). A ferroelectric capacitor 22 is shown as part of cell 10, using the schematic notation which we have adopted for ferroelectric capacitors. Capacitor 22 includes first and second electrodes or plates 24, 26 which are spaced apart and between which is located a ferroelectric dielectric material. First plate 24 is coupled to source 18. Second plate 26 is coupled either to ground (VSS) or, optionally, to a plate line (P) at 28.

Figure 2 shows one embodiment of the present invention and corresponds electrically to Figure 1. Thus, on a silicon substrate 30, P+ or N+ diffusions or regions 14, 18 are established, and these correspond to the drain and source of the transistor 12. A self-aligned gate process can be used. Gate electrode 16 is shown in Figure 2 separated from the upper surface of substrate 30 by a gate oxide. Gate electrode 16 is formed illustratively of polysilicon, and corresponds to and is part of the word line. That is to say, this memory cell can be used in an array of memory cells having word lines and bit lines. The array comprises a set of rows orthogonal to a set of columns. Other substances can be used for the gate electrode, so long as they are conductive. Thus, while doped polysilicon can be used, other combinations such as "polycides" or metal could be substituted, or other conductive substances.

A bit line 20a is shown contacting the upper surface of drain region 14. It will be understood that bit lines ordinarily are metallic, but again nonmetallic conductors, including doped polycide or doped polysilicon, could be substituted.

On the right side of Figure 2, a ferroelectric material 32 is located in a contact hole over source region 18. Preferably material 32 comprises PZT. Preferably, the interface between dielectric 32 and diffusion 18 comprises a silicided source contact 24a formed illustratively of platinum silicide or another suitable metal (or metal-like) interface that forms the bottom electrode 24 of ferroelectric capacitor 22. This interface is included in Fig. 2 because a metal or metal-like electrode is required between PZT and an n+ or p+ source region to permit or facilitate switching by the capacitor. The electrode might be eliminated if switching could be achieved without it. Above dielectric 32 is an upper contact 26a, formed illustratively of platinum. Above electrode 26a is the metallic ground line or plate line 28a. It will be understood that electrode 26a and line 28a could be combined in a modification of the Fig. 2 embodiment.

Other portions of this structure include field oxide 33 as well as further oxides or dielectrics 34, as are customary.

It will be understood that after the processing stage represented by Figure 2, a passivation layer such as BPSG or PSG (phosphosilicate glass) may be added.

A method for forming this structure will now be described.

After formation of source and drain regions adjacent a gate electrode, where the gate electrode is covered on its top and sides with a dielectric such as oxide, contact windows approximately 1 micron by 1 micron are opened to the source, drain, and preferably gate electrode. A platinum silicide layer is then formed, using standard, well known techniques, in an amount sufficient to cover the exposed upper surfaces of the substrate over the source and drain regions.

Next, the ferroelectric material is applied. Preferably, the ferroelectric is lead zirconate titanate (PZT). This can be applied by a standard spin-on process, which is either sol-gel or MOD (Metal Organic Decomposition). This step is preferably done by a spin-on process, because such a process would automatically fill the contact windows thereby to allow a simple anisotropic etch back to be performed to clear all of the noncontact window portions of the circuit of PZT. However, other processes can be used to form this intermediate structure.

The next step in the preferred process is to etch back the PZT but leave it in the contact windows. This etch preferably is an anisotropic dry etch (plasma etch or reactive ion etch).

Next, the PZT is etched out of the drain and gate contact windows, so that PZT remains only over the source region in the contact window. At this point, the upper surface of the drain region again becomes exposed (for subsequent contact to the bit line). An additional mask is used for this step of the process. For example, the source electrodes are masked, and PZT is removed from all unmasked regions.

Next, the top electrode 26a is formed to a thickness of approximately 1000 to 2000 angstroms. As mentioned, this illustratively comprises a platinum layer, which can be formed according to any well known technique. Alternatively, this electrode material may be applied prior to the second PZT etch, thereby to save a masking step. The second PZT etch would then comprise etching the PZT as well as etching or defining the top electrode.

Finally, after the PZT has been etched out of the drain and gate contact windows and the top capacitor electrode has been formed, standard processing proceeds, including metallization and passivation. The metallization includes adding the bit line over and within the contact window for the drain region as well as providing contact to the word line. If maximum packing density is required, an interlevel dielectric layer can be applied after the first metallization layer 28, followed by a second metallization for bit line 20, as in the second embodiment, to which we now turn.

Figure 3 illustrates a slightly varied embodiment of the invention showing how the passivation layer can be configured. As evident from Fig. 1, bit line 20 and ground or plate line 28 are electrically isolated from each other. To achieve a minimum area cell, it can be advantageous to introduce an additional level of metallization. An interlevel dielectric of PSG of BPSG for example is deposited or otherwise established on top of metal line 28b which may act as VSS or a plate line. This dielectric layer 40 may have a thickness illustratively of one micron. A bit line 20b is then deposited and formed thereover. The other parts of the process are the same.

This second embodiment has an advantage of inherent planarization caused by metal layer/bit line 20b, which is generally planar over interlevel dielectric 40 and which plugs the contact window to drain region 14.

These structures will provide sufficient signal even with a technology using one or two micron design rules. If the switched charge is approximately 20 microcoulombs per square centimeter, and the linear charge is approximately 10 microcoulombs per square centimeter, then the signal charge is equal to the difference between them which is 10 microcoulombs per square centimeter. For a contact window which is one micron by one micron, the switched charge is approximately 10⁻¹³ coulombs.

In a standard circuit architecture, the signal generated on a bit line with one picofarad capacitance is 100 millivolts-- which is larger than the minimum required signal to be sensed.

For a nonvolatile ferroelectric random access memory, the described structures offer a small cell area with a simplified process flow, as well as the added advantage of partial planarization. The structures also present substantial advantages for volatile DRAMs. Volatile DRAMs have the added requirement of a capacitor value that should fall no lower than 50 femtofarads. If the capacitance falls below this, the soft error rate due to alpha particles will become unacceptably high. High density DRAMs, however, in modern technologies, require all dimensions to be scaled to the limits consistent with photolithography and etch capabilities in order to be competitive. Starting with the 4 Mbit generation, it became necessary to add a third dimension to the structure, with the most popular approach being a trench capacitor about 4 to 5 microns deep. This trench technology is very complicated and adds several additional mask steps to the process. The dielectric constant of PZT will give a capacitance value of sufficient magnitude without a trench even with geometries of near 1 micron. Operating the proposed structure as a volatile memory cell would allow the plate line to be grounded. The two modes of operation could be combined, however, creating a nonvolatile DRAM which would work as a volatile DRAM, with refreshing required, in the active mode. However, information would be stored by the cell in nonvolatile fashion if power is lost by polarizing the dipoles of the ferroelectric material.

It will be appreciated that the present invention can be implemented in other semiconductor technologies, including gallium arsenide, bipolar, silicon on sapphire, silicon on insulator, and others. Accordingly, this description is intended to be taken in the illustrative sense, and the scope of protection afforded is to be measured with reference to the following claims.

## Claims

1. A compact one transistor, one capacitor memory cell for an integrated circuit memory comprising:
first and second spaced apart isolation regions (33) with a substrate therebetween;
spaced apart source and drain regions (14,18) with a gate electrode (16) therebetween but above the substrate, including a gate dielectric (34) on the top and sides of the gate electrode;
contact windows to the source and drain regions;
a capacitor electrode (24a;24b) in the contact window for the source region;
a layer of a high dielectric constant ferroelectric material (32) in the contact window for the source region;
an upper capacitor electrode (26a;26b) upon the layer of ferroelectric material over the source region;
a bit line conductor (20a;20b) contacting the drain and a further conductor (28) in contact with the upper capacitor electrode, the upper surfaces of the bit line conductor and the further conductor being above the gate dielectric upper surface and being substantially planar so as to obtain a substantially planar upper memory cell surface.

2. A memory cell according to claim 1 wherein said gate electrode (16) provides a word line (WL).

3. A memory cell according to claim 1 or 2 further comprising interlevel dielectric (40) located over said further conductor (28b), said gate electrode, said ferroelectric material and other portions of the substrate, said bit line conductor extending through said interlevel dielectric at said drain contact window, said bit line conductor generally planarizing said memory cell.

4. A cell according to claim 1 or 2 wherein the substantially planar surface of the cell comprises the upper surface of the bit line conductor (20b).

5. A cell according to claim 1 or 2 wherein the substantially planar upper surface of the cell comprises the upper surface of said further conductor (28a).

6. A cell according to claim 4 wherein said substantially planar surface is formed by the upper surface of only the bit line conductor (20b).

7. A cell according to claim 6 further comprising a dielectric material (40) insulating said further conductor (28b) from said bit line conductor (20b).

8. A cell according to any preceding claim wherein substantially all of said capacitor (22) is planar and parallel to the substrate.

9. A cell according to any preceding claim wherein the space between the upper and lower plates includes no layer of low dielectric constant.

10. A cell according to any preceding claim wherein the upper surface of said ferroelectric material (32) is no higher than the upper surface of the gate insulation (34) formed on top of said gate electrode (16).

11. A cell according to any preceding claim wherein said ferroelectric layer material does not rise above the upper surface of the second isolation region (33).

12. A cell according to any preceding claim wherein the capacitor substantially fills the region defined between the gate electrode (16) with its insulation (34) and the second isolation region.

13. A cell according to claim 4 wherein the cell further comprises a further insulation layer (40) insulating the bit line conductor (20b) from the further conductor (28b), the bit line conductor upper surface covering the upper surface of the further conductor in the region between the first and second spaced isolation regions (33).

14. A cell according to claim 13 wherein the further insulation layer comprises a phosphosilicate glass (40).

15. A cell according to any preceding claim wherein the ferroelectric material comprises lead zirconate titanate (PZT) (32).

16. A method of forming a compact one transistor, one capacitor memory cell for an integrated circuit memory comprising the steps of:
forming first and second spaced apart isolation regions (33) with substrate therebetween;
forming spaced apart source and drain regions (14,18) with a gate electrode (16) therebetween but above the substrate, including forming gate dielectric (34) on the top and sides of the gate electrode;
the method including opening contact windows to the source and drain regions;
forming a capacitor electrode (24a;24b) in the contact window for the source region;
adding a layer of a high dielectric constant ferroelectric material (32) in the contact window for the source region and etching back the ferroelectric material so that portions thereof remain in only the contact windows;
removing the ferroelectric material from the drain contact window;
forming an upper capacitor electrode (26a;26b) upon the ferroelectric layer over the source region;
forming a bit line conductor (20a;20b) contacting the drain and forming a further conductor in contact with the upper capacitor electrode, the upper surfaces of the bit line conductor and the further conductor being above the gate dielectric upper surface and being substantially planar, whereby a substantially planar upper memory cell surface is obtained.

17. The method of claim 16 wherein said last named step further includes forming a further insulation layer (40) above the further conductor, and the forming of the bit line conductor comprises forming the bit line conductor to have a portion on top of the further insulation layer thereby to insulate the further conductor from the bit line conductor, the formation of the bit line conductor occurring after the formation of the further insulation, the bit line conductor being formed to have a substantially planar upper surface.

## Patentansprüche

1. Kompakte Eintransistor-Einkondensator-Speicherzelle für einen Integrierte-Schaltungs-Speicher mit:
einem ersten und einem zweiten Isolationsbereich (33), die voneinander beabstandet, mit einem Substrat dazwischen, angeordnet sind;
einem Source- und einem Drain-Bereich (14, 18), die voneinander beabstandet angeordnet sind, mit einer dazwischen, aber oberhalb des Substrats, liegenden Gateelektrode (16), umfassend ein Gate-Dielektrikum (34) an der Oberseite und den Seiten der Gateelektrode;
Kontaktfenstern zum Source- und Drainbereich;
einer Kondensatorelektrode (24a; 24b) im Kontaktfenster für den Sourcebereich;
einer Schicht aus ferroelektrischem Material (32) mit hoher Dielektrizitätskonstante im Kontaktfenster für den Sourcebereich;
einer oberen Kondensatorelektrode (26a; 26b) auf der Schicht aus ferroelektrischem Material über dem Sourcebereich;
einem Bitleitungs-Leiter (20a; 20b) in Kontakt mit dem Drain und einem weiteren Leiter (28) in Kontakt mit der oberen Kondensatorelektrode, wobei die oberen Oberflächen des Bitleitungs-Leiters und des weiteren Leiters oberhalb der oberen Oberfläche des Gate-Dielektrikums liegen und im wesentlichen eben sind, um eine im wesentlichen ebene obere Speicherzellen-Oberfläche zu erhalten.

2. Speicherzelle nach Anspruch 1, bei welcher die genannte Gateelektrode (16) eine Wortleitung (WL) bereitstellt.

3. Speicherzelle nach Anspruch 1 oder 2, ferner mit einem Zwischenniveau-Dielektrikum (40), das über dem weiteren Leiter (28b), der Gateelektrode, dem ferroelektrischen Material und anderen Abschnitten des Substrats gelegen ist, wobei sich der Bitleitungs-Leiter durch das Zwischenniveau-Dielektrikum am Drain-Kontaktfenster erstreckt, und wobei der genannte Bitleitungs-Leiter die Speicherzelle im allgemeinen eben macht.

4. Zelle nach Anspruch 1 oder 2, bei welcher die im wesentlichen ebene Oberfläche der Zelle die obere Oberfläche des Bitleitungs-Leiters (20b) umfaßt.

5. Zelle nach Anspruch 1 oder 2, bei welcher die im wesentlichen ebene Oberfläche der Zelle die obere Oberfläche des weiteren Leiters (28a) umfaßt.

6. Zelle nach Anspruch 4, bei welcher die im wesentlichen ebene Oberfläche von der oberen Oberfläche nur des Bitleitungs-Leiters (20b) gebildet ist.

7. Zelle nach Anspruch 6, ferner mit einem dielektrischen Material (40), das den weiteren Leiter (28b) von dem Bitleitungs-Leiter (20b) isoliert.

8. Zelle nach irgendeinem vorangehenden Anspruch, bei welcher im wesentlichen der gesamte Kondensator (22) eben und parallel zum Substrat ist.

9. Zelle nach irgendeinem vorangehenden Anspruch, bei welcher der Raum zwischen der oberen und unteren Platte keine Schicht mit niedriger Dielektrizitätskonstante umfaßt.

10. Zelle nach irgendeinem vorangehenden Anspruch, bei welcher die obere Oberfläche des ferroelektrischen Materials (32) nicht höher ist als die obere Oberfläche der Gateisolierung (34), die auf der Oberseite der Gateelektrode (16) ausgebildet ist.

11. Zelle nach irgendeinem vorangehenden Anspruch, bei welcher das Material der ferroelektrischen Schicht sich nicht über die obere Oberfläche des zweiten Isolationsbereichs (33) erhebt.

12. Zelle nach irgendeinem vorangehenden Anspruch, bei welcher der Kondensator im wesentlichen den Bereich ausfüllt, der zwischen der Gateelektrode (16) mit ihrer Isolation (34) und dem zweiten Isolationsbereich begrenzt ist.

13. Zelle nach Anspruch 4, bei welcher die Zelle ferner eine weitere Isolationsschicht (40) umfaßt, die den Bitleitungs-Leiter (20b) von dem weiteren Leiter (28b) isoliert, wobei die obere Oberfläche des Bitleitungs-Leiters die obere Oberfläche des weiteren Leiters im Bereich zwischen dem ersten und zweiten beabstandeten Isolationsbereich (33) bedeckt.

14. Zelle nach Anspruch 13, bei welcher die weitere Isolationsschicht ein Phosphosilicatglas (40) umfaßt.

15. Zelle nach irgendeinem vorangehenden Anspruch, bei welcher das ferroelektrische Material Bleizirconattitanat (PZT) (32) umfaßt.

16. Verfahren zum Bilden einer kompakten Eintransistor-Einkondensator-Speicherzelle für einen Integrierte-Schaltungs-Speicher, umfassend folgende Schritte:
Bilden eines ersten und eines zweiten Isolationsbereichs (33), die voneinander beabstandet, mit einem Substrat dazwischen, angeordnet sind;
Bilden eines Source- und eines Drainbereichs (14, 18), die voneinander beabstandet angeordnet sind, mit einer dazwischen, aber oberhalb des Substrats, liegenden Gateelektrode (16), umfassend ein Bilden eines Gate-Dielektrikums (34) auf der Oberseite und den Seiten der Gateelektrode;
wobei das Verfahren das Öffnen von Kontaktfenstern zum Source- und Drainbereich umfaßt;
Bilden einer Kondensatorelektrode (24a; 24b) im Kontaktfenster für den Sourcebereich;
Hinzufügen einer Schicht aus ferroelektrischem Material (32) mit hoher Dielektrizitätskonstante im Kontaktfenster für den Sourcebereich und Rückätzen des ferroelektrischen Materials, so daß Abschnitte hiervon nur in den Kontaktfenstern verbleiben;
Entfernen des ferroelektrischen Materials vom Drain-Kontaktfenster;
Bilden einer oberen Kondensatorelektrode (26a; 26b) auf der ferroelektrischen Schicht über dem Sourcebereich;
Bilden eines Bitleitungs-Leiters (20a; 20b), der den Drain kontaktiert, und Bilden eines weiteren Leiters in Kontakt mit der oberen Kondensatorelektrode, wobei die oberen Oberflächen des Bitleitungs-Leiters und des weiteren Leiters oberhalb der oberen Oberfläche des Gate-Dielektrikums liegen und im wesentlichen eben sind, wodurch eine im wesentlichen ebene obere Speicherzellenoberfläche erhalten wird.

17. Verfahren nach Anspruch 16, bei welchem der letztgenannte Schritt ferner das Bilden einer weiteren Isolationsschicht (40) oberhalb des weiteren Leiters umfaßt und das Bilden des Bitleitungs-Leiters das Bilden des Bitleitungs-Leiters derart umfaßt, daß ein Abschnitt auf der Oberseite der weiteren Isolationsschicht liegt, um hierdurch den weiteren Leiter von dem Bitleitungs-Leiter zu isolieren, wobei das Bilden des Bitleitungs-Leiters nach dem Bilden der weiteren Isolation stattfindet, und wobei der Bitleitungs-Leiter so gebildet wird, daß er eine im wesentlichen ebene obere Oberfläche aufweist.

## Revendications

1. Cellule de mémoire compacte à un transistor, un condensateur, pour une mémoire à circuit intégré, comportant :
des première et seconde régions espacées (33) d'isolement avec un substrat entre elles ;
des régions espacées (14, 18) de source et de drain avec une électrode de grille (16) entre elles, mais au-dessus du substrat, comprenant un diélectrique de grille (34) sur le dessus et les côtés de l'électrode de grille ;
des fenêtres pour contacts vers les régions de source et de drain ;
une électrode (24a ; 24b) de condensateur dans la fenêtre de contact pour la région de source ;
une couche d'une matière ferroélectrique (32) à constante diélectrique élevée dans la fenêtre de contact pour la région de source ;
une électrode supérieure (26a ; 26b) de condensateur sur la couche de matière ferroélectrique au-dessus de la région de source ;
un conducteur (20a ; 20b) de ligne de bits en contact avec le drain et un autre conducteur (28) en contact avec l'électrode supérieure de condensateur, les surfaces supérieures du conducteur de ligne de bits et de l'autre conducteur étant au-dessus de la surface supérieure du diélectrique de grille et étant sensiblement planes afin que l'on obtienne une surface supérieure sensiblement plane de la cellule de mémoire.

2. Cellule de mémoire selon la revendication 1, dans laquelle ladite électrode (16) de grille procure une ligne de mots (WL).

3. Cellule de mémoire selon la revendication 1 ou 2, comportant en outre un diélectrique intercouche (40) situé au-dessus dudit autre conducteur (28b), de ladite électrode de grille, de ladite matière ferroélectrique et d'autres parties du substrat, ledit conducteur de ligne de bits s'étendant à travers ledit électrique intercouche à ladite fenêtre de contact de drain, ledit conducteur de ligne de bits donnant à ladite cellule de mémoire une structure globalement plane.

4. Cellule selon la revendication 1 ou 2, dans laquelle la surface sensiblement plane de ladite cellule comprend la surface supérieure du conducteur (20b) de ligne de bits.

5. Cellule selon la revendication 1 ou 2, dans laquelle la surface supérieure sensiblement plane de la cellule comprend la surface supérieure dudit autre conducteur (28a).

6. Cellule selon la revendication 4, dans laquelle ladite surface sensiblement plane est formée par ladite surface supérieure du conducteur (20b) de ligne de bits uniquement.

7. Cellule selon la revendication 6, comportant en outre une matière diélectrique (40) isolant ledit autre conducteur (28b) dudit conducteur (20b) de ligne de bits.

8. Cellule selon l'une quelconque des revendications précédentes dans laquelle sensiblement la totalité dudit condensateur (22) est plane et parallèle au substrat.

9. Cellule selon l'une quelconque des revendications précédentes, dans laquelle l'espace entre les plaques supérieure et inférieure ne comprend aucune couche à faible constante diélectrique.

10. Cellule selon l'une quelconque des revendications précédentes, dans laquelle la surface supérieure de ladite matière ferroélectrique (22) n'est pas plus élevée que la surface supérieure de l'isolant de la grille (34) formé sur le dessus de ladite électrode de grille (16).

11. Cellule selon l'une quelconque des revendications précédentes, dans laquelle ladite matière de la couche diélectrique ne s'élève pas au-dessus de la surface supérieure de la seconde région (33) d'isolement.

12. Cellule selon l'une quelconque des revendications précédentes, dans laquelle le condensateur remplit sensiblement la région définie entre l'électrode de grille (16) avec son isolant (34) et la seconde région d'isolement.

13. Cellule selon la revendication 4, dans laquelle la cellule comporte en outre une autre couche d'isolant (40) isolant le conducteur (20b) de ligne de bits de l'autre conducteur (28b), la surface supérieure du conducteur de ligne de bits couvrant la surface supérieure de l'autre conducteur dans la région située entre les première et seconde régions espacées (33) d'isolement.

14. Cellule selon la revendication 13, dans laquelle l'autre couche d'isolant comprend un verre (40) au phosphosilicate.

15. Cellule selon l'une quelconque des revendications précédentes, dans laquelle la matière ferroélectrique comprend du zirconate-titanate de plomb (PZT) (32).

16. Procédé de formation d'une cellule de mémoire compacte à un transistor, un condensateur, pour une mémoire à circuit intégré, comprenant les étapes qui consistent :
à former des première et seconde régions espacées (33) d'isolant avec un substrat entre elles ;
à former des régions espacées (14, 18) de source et de drain avec une électrode de grille (16) entre elles, mais au-dessus du substrat, comprenant la formation d'un diélectrique de grille (34) sur le dessus et les côtés de l'électrode de grille ;
le procédé comprenant l'ouverture de fenêtres de contact vers les régions de source et de drain ;
la formation d'une électrode de condensateur (24a, 24b) dans la fenêtre de contact pour la région de source ;
l'addition d'une couche d'une matière ferroélectrique (32) à constante diélectrique élevée dans la fenêtre de contact pour la région de source et l'attaque chimique de la matière ferroélectrique afin que des parties de celle-ci restent uniquement dans les fenêtres de contact ;
l'enlèvement de la matière ferroélectrique de la fenêtre de contact de drain ;
la formation d'une électrode supérieure (26a ; 26b) de condensateur sur la couche ferroélectrique au-dessus de la région de source ;
la formation d'un conducteur (20a ; 20b) de ligne de bits en contact avec le drain et la formation d'un autre conducteur en contact avec l'électrode supérieure de condensateur, des surfaces supérieures du conducteur de ligne de bits et de l'autre conducteur étant au-dessus de la surface supérieure du diélectrique de grille et étant sensiblement planes, grâce à quoi une surface supérieure sensiblement plane de cellule de mémoire est obtenue.

17. Procédé selon la revendication 16, dans lequel ladite dernière étape citée comprend en outre la formation d'une autre couche (40) d'isolant au-dessus de l'autre conducteur, et la formation du conducteur de ligne de bits comprend la formation du conducteur de ligne de bits afin qu'il ait une partie sur le dessus de l'autre couche d'isolant, afin d'isoler l'autre conducteur du conducteur de ligne de bits, la formation du conducteur de lignes de bits ayant lieu après la formation de l'autre isolant, le conducteur de ligne de bits étant formé de façon à avoir une surface supérieure sensiblement plane.
